# EUROPEAN PATENT SPECIFICATION

(11) **EP 3 420 616 B1**
(45) Date of publication and mention of the grant of the patent: **11.08.2021**
(21) Application number: 17711319.8
(22) Date of filing: 31.01.2017
(51) Int. Cl.: H02B 1/052, H02B 1/20, H01R 25/14, H05K 7/14

(54) **MOUNTING RAIL FOR MODULAR ELECTRICAL APPARATUSES FOR THE CONTROL AND/OR DISTRIBUTION OF ELECTRIC POWER COMPRISING AN INTERCONNECTION BUS**
MONTAGESCHIENE FÜR MODULARE ELEKTRISCHE VORRICHTUNGEN ZUR STEUERUNG UND/ODER VERTEILUNG ELEKTRISCHER ENERGIE MIT EINEM VERBINDUNGSBUS
RAIL DE MONTAGE POUR APPAREILS ÉLECTRIQUES MODULAIRES EN VUE DE LA RÉGULATION ET/OU DE LA DISTRIBUTION D'ÉNERGIE ÉLECTRIQUE COMPRENANT UN BUS D'INTERCONNEXION

(30) Priority: 26.02.2016 IT UB20161126
(43) Date of publication of application: 02.01.2019
(73) Proprietor: BTICINO S.P.A., 21100 Varese (VA) (IT)
(72) Inventor: CIROLINI, Andrea, 21100 Varese (IT); BRIATICO, Andrea, 21100 Varese (IT)
(74) Representative: Carangelo, Pierluigi
(86) International application number: PCT/IB2017/050503
(87) International publication number: WO 2017/144991

(56) References cited:
- DE-A1-102006 031 129
- DE-A1-102010 016 865
- DE-A1-102011 001 274
- US-A1- 2015 126 053

## Description

### SCOPE OF THE INVENTION

The present invention relates to the technical field of modular electrical equipment for the control and/or distribution of electric power and concerns in particular a mounting rail for modular electrical apparatuses comprising an interconnection bus.

### STATE OF THE ART

Systems have long been known of for the control and/or the distribution of electric power in which a plurality of modular electrical apparatuses are installed alongside one another on a mounting rail, for example housed inside an electrical switchboard. For the attachment of the electrical modular apparatuses to the mounting rail it is known of to provide on a rear face of the electrical apparatuses a housing recess adapted to partially receive the mounting rail. The mounting rail is generally a bar made of a metal profile, and usually has a hat profile, including two longitudinal fastening bands to which it is possible to mechanically fasten the modular electrical apparatuses.

With the passage of time the aforesaid systems for the control and/or distribution of electric power have undergone a continual evolution up to the point of allowing an interconnection to be made for the exchange of data and/or signals between the modular electrical apparatuses and/or between the modular electrical apparatuses and a control centre, such as a remote control centre. To this end, systems have been developed for the control and/or the distribution of electric power in which inside the mounting rail an interconnection bus is provided adapted to provide the electrical apparatuses with data connection functions to other electrical apparatuses and/or to a control centre.

Patent application US2013/294035A1 describes a solution of a known system which provides for the housing of a T-bus connector inside the mounting rail.

Document DE202014100115U1 describes a modular system in which the housing of an interconnection bus is provided for inside a mounting rail for modular electrical apparatuses. The document DE 10 2010 016865 A1 discloses a mounting rail for modular electrical apparatuses for the control and/or distribution of electricity.

In the systems of the prior art however, the attachment of the interconnection bus to the mounting rail is problematic. In some cases the mechanical attachment of the interconnection bus to the modular electrical apparatuses is provided for, which does not allow a rapid coupling of the modular electrical apparatuses to the mounting rail. In other cases, the interconnection bus is fixed to the mounting rail and to such purpose external locking devices are provided, such as C-shaped hooks adapted to hook to the outside of the longitudinal fastening bands of the mounting rail, thereby subtracting useful space from the mounting rail which could otherwise be used to secure the modular electrical apparatuses to said mounting rail.

The purpose of the present description is to provide a mounting rail for modular electrical apparatuses with an interconnection bus which solves, or reduces at least in part, the drawbacks of mounting rails with interconnection buses of the prior art.

Such purpose is achieved by of a mounting rail as generally defined in claim 1. Preferred and advantageous embodiments of the aforesaid rail are defined in the appended dependent claims.

The invention will be clearer to understand from the following detailed description of a particular embodiment, made by way of a non-limiting example with reference to the appended drawings, briefly described in the following paragraph.

### BRIEF DESCRIPTION OF THE DRAWINGS

Figure 1 shows a front plan view of an example of a system for the control and/or the distribution of electric power comprising a plurality of modular electrical apparatuses and a mounting rail, in which the modular electrical apparatuses are shown attached to the mounting rail.
Figure 2 shows a side view of a modular electrical apparatus fixed to the mounting rail.
Figure 3 shows a perspective view in which a portion of the rear face of the electrical apparatus in Figure 2 is visible.
Figure 4 shows a perspective view of a portion of the mounting rail in figure 1.
Figure 5 shows a perspective view of an enlarged portion of the mounting rail complying with the example shown in figure 2, comprising an interconnection bus and a support device of the interconnection bus made according to a first embodiment.
Figure 6 shows a perspective view of a part of the interconnection bus and of the support device of the interconnection bus in figure 5.
Figure 7 shows a perspective view of a second embodiment of the interconnection bus and of the support device of the interconnection bus.
Figure 8 shows a side view in cross-section of an alternative embodiment of the mounting rail in figure 5, comprising an interconnection bus, a support device of the interconnection bus and an adapter device, in which a modular electrical apparatus is shown installed on the rail.
Figure 9 shows a perspective view of the interconnection bus, the support device of the interconnection bus and the adapter device in figure 8.
Figure 10 shows a rear perspective view of the assembly in figure 9 to which a terminal cap has been added.

### DETAILED DESCRIPTION

With reference to the appended drawings, reference numeral 1 denotes a modular system for the control and/or the distribution of electric power comprising a mounting rail 2 and a plurality of modular electrical apparatuses 3-9 fixed to the mounting rail 2.

The plurality of modular electrical apparatuses 3-9 comprises, for example, one or more modular circuit breakers 3,5, such as magnetothermic or differential circuit breakers, and/or and one or more auxiliary modular electrical apparatuses 4,6,-9 associated with the modular circuit breakers 3,5 and adapted to provide said circuit breakers with additional functions compared to the basic functions of said circuit breakers. The latter is represented by the ability to connect and disconnect from each other selectively a power network and a load network. Some non-limiting examples of possible auxiliary modular electrical apparatuses 4,6-9 are: measuring apparatuses which perform voltage and/or current measurements, automatic control apparatuses adapted to control the modular circuit breakers 3, 5, to turn them on/off, apparatuses adapted to detect whether an associated modular circuit breaker is on/off, apparatuses adapted to remotely communicate acquired information about the status of the modular circuit breakers (such as, for example, one-way or two-way communication interface devices), devices with a voltage regulator for powering auxiliary devices starting from the voltage of the electric power distribution network.

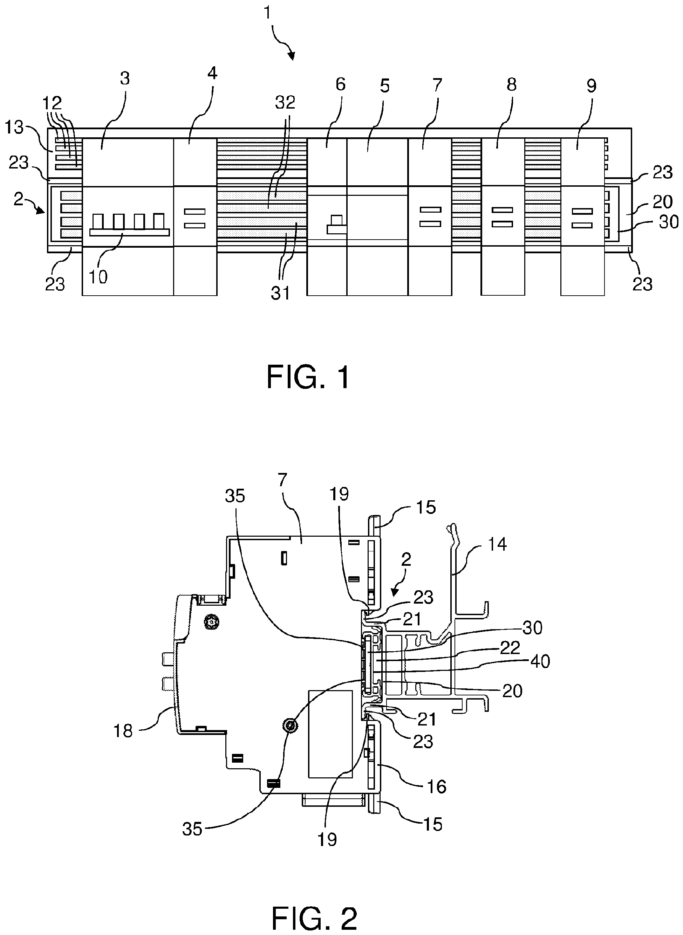

In the particular example in figure 1, in the control and/or distribution system of electric power the plurality of modular electrical apparatuses 3-9 comprises two modular circuit breakers 3, 5, one of which (and in particular the modular circuit breaker 3) is for example controlled via a manual control lever 10 which allows an operator to manually turn on and off the modular circuit breaker 3. In the example, the plurality of modular electrical apparatuses 3-9 further comprises an auxiliary apparatus 4 adapted to detect the on /off status of the modular circuit breaker 3, a motor-driven auxiliary apparatus 6 adapted to automatically re-arm the modular circuit breaker 5, a auxiliary apparatus 7 adapted to detect the on/off status of the modular circuit breaker 5, an auxiliary communication interface apparatus 8, an auxiliary power supply apparatus 9 adapted to power the auxiliary apparatuses 4,6,7,8. According to one embodiment the motor-driven auxiliary apparatus 6 is made according to the teachings of European patent application EP 2383766 A1.

The modular circuit breakers 3,5 and the auxiliary power supply apparatus 9 are connected to an AC power supply network, preferably at low voltage, for example by means of a group of parallel conductive electric power distribution bars 12. For example, the modular circuit breakers 3, 5 and the auxiliary power supply apparatus 9 are electrically connected to the parallel conductive bars 12 by means of a fast coupling system, of the type described in the European patent EP2104193B1. For example, the parallel conductive bars 12 are fixed to a support structure 13 made of insulating material coupled to the mounting rail 2. For example the support structure 13 is hooked to a fastening wall 14 of the mounting rail 2. To simplify the drawings, the group of parallel conductive bars 12 and the support structure 13 have been represented only in figure 1, such elements also being optional given that the connection of the modular circuit breakers 3, 5 and of the auxiliary power supply apparatus 9 to the electric power distribution network can be achieved by alternative methods, for example according to the teachings of the European patent EP0798835A1 or of the European patent EP0434964B1. It is clear that the modular circuit breakers 3, 5 having to establish and selectively interrupt a connection between the electric power distribution network and the load networks are also electrically connected each to a respective load network, but this can be achieved in a manner known per se to a person skilled in the art, for example by providing screw connection terminals in the modular circuit breakers 3,5, reason for which this aspect will not be described in greater detail herein.

The mounting rail 2 comprises a profile, for example a metal profile, preferably of aluminium, having a bottom wall 20 and two side walls 21 connected to the bottom wall 20 and such as to define together with the bottom wall 20 a recessed channel 22 of the mounting rail 2. The profile is for example a so-called hat profile. The profile comprises two fastening bands 23, each of which is joined to a respective side wall 21 and which together define a mounting rail of the modular electrical apparatuses 3-9. In other words, the modular electrical apparatuses 3-9 are coupled to the mounting rail 2 being provided with coupling elements to the rail 19 adapted to engage with the mounting rail consisting of the two fastening bands 23. For example, the coupling elements to the rail 19 are for each of the modular apparatuses 3-9 two opposite coupling teeth placed at opposite ends of two sliders 15 slidingly constrained to a back face 16 of the housing modular apparatuses 3-9. Back face 16 is taken to mean a face of the modular electrical apparatuses 3-9 which in an installation configuration is facing the mounting rail 2 and is opposite a front face 18 of the of the modular electrical apparatuses which in such installation configuration is instead facing an operator. For example, the aforementioned teeth coupling to the rail 19 and the aforesaid sliders 15 are part of a coupling device to the rail as described in the European patent EP2003754B1.

The mounting rail 2 comprises an interconnection bus 30 and between modular electrical apparatuses 3-9 and a support device 40 adapted to attach the interconnection bus 30 to the mounting rail 2. For the purposes of the present description the interconnection bus is understood to be a DC power supply bus (Direct Current) and/or a data communication bus.

The interconnection bus 30 comprises a plurality of electric lines 31, 32 parallel to each other. Such electric lines 31, 32 are for example electrically conductive lines placed on, or in, a support 33 in electrically insulating material.

In the example, the interconnection bus 30 comprises a pair of DC power supply lines 31 and a pair of data communication lines 32. The DC power supply lines 31 are, for example, powered by a DC voltage, such as a SELV (Safety Extra Low Voltage) voltage, designed to provide power to the auxiliary modular electrical apparatuses 4-5, 7, 9. In general the modular circuit breakers 3,5 do not require a power supply voltage supplied via the interconnection bus 30 since, if such modular circuit breakers 3,5 are electromechanical circuit breakers, they do not require a continuous power supply voltage while, if such modular circuit breakers 3,5 are electronic circuit breakers, they may include within them voltage regulators adapted to obtain a continuous DC voltage starting from the voltage supplied by the parallel conductive distribution bars 12 of AC voltage electric power. However this does not rule out that if the modular circuit breakers 3, 5 require a DC supply voltage these can be connected to the DC power supply lines 31 of the interconnection bus 30. For the above reasons, in the present description reference will be made to the non-limiting case in which only the auxiliary electrical apparatuses 4, 6, 7, 8, 9 are connected to the DC power supply lines 31 of the interconnection bus 30. It is also possible to provide that, while some auxiliary electrical apparatuses 4, 6, 7, 8 are connected to the DC electric power supply lines 31 of the interconnection bus 30 to be powered, there is an auxiliary apparatus 9 for powering the DC electric power supply lines 31, for example by converting, using a voltage regulator circuit, an alternating voltage withdrawn by the parallel conductive electric power distribution bars 12, into a DC voltage for example in a SELV or PELV voltage.

The data communication lines 32 of the interconnection bus 30 are electric lines by means of which, using a communication protocol, it is possible to realize an exchange of data between modular electrical apparatuses 3-9. The data communication lines 32 thus make it possible to realize a shared data communication channel between the modular electrical apparatuses 3-9 fixed to the mounting rail 2. For simplicity in this case too it will be assumed, without thereby introducing any limitation, that only the auxiliary electrical apparatuses 4, 6, 7, 8 and possibly also the auxiliary apparatus 9 are connected to the data communication lines 32 of the interconnection bus 30. Therefore, in the rest of the present description reference will be made only to the auxiliary modular electrical apparatuses 4, 6, 7, 8, 9 but the teachings may be applied to modular devices of a different type, for example to the modular circuit breakers 3, 5.

The above-mentioned shared data communication channel can be used for the exchange of data between the auxiliary modular electrical apparatuses 4, 6, 7, 8 and 9 and/or to allow the auxiliary electrical apparatuses to communicate only with the communication interface electrical apparatus 8, for example to transmit signals over a distance with status information and/or in order to receive remote signals with control information. In this case, for example, the electrical communication interface apparatus 8 is a network interface device which for example can be connected to a local network, for example an Ethernet network to ensure the network connection of the other modular electrical apparatuses connected to the data lines 32 of the interconnection bus 30.

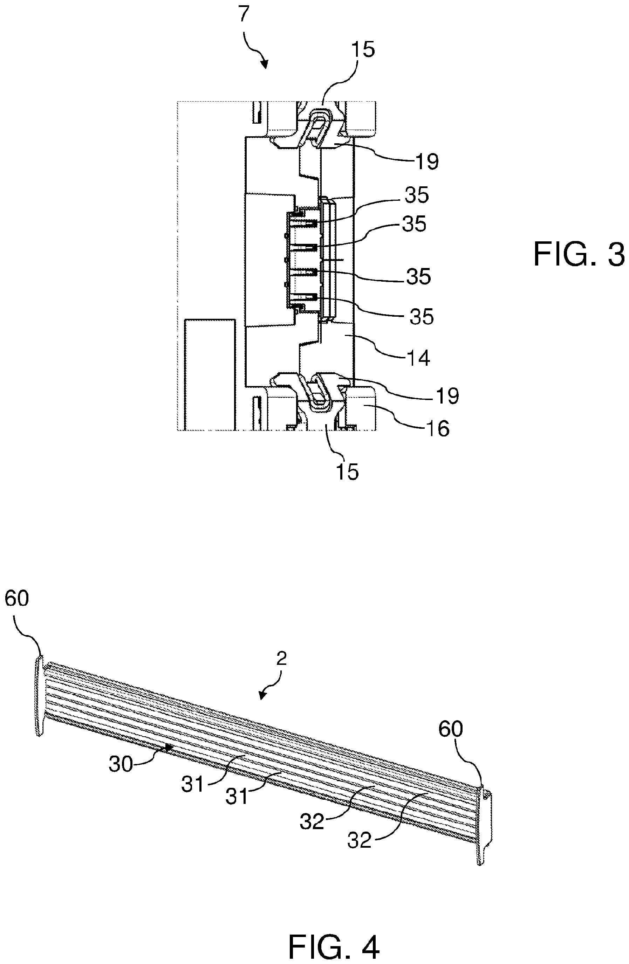

With reference to Figure 3, for connection of the auxiliary modular electrical apparatuses to the interconnection bus 30, the auxiliary modular electrical apparatuses may be provided with a plurality of elastic contact conductive elements 35 each of which, when the auxiliary modular electrical apparatuses are fixed to the mounting rail 2, is such as to interfere in abutment with a respective conductive line 31, 32 of the interconnection bus 30. In the particular example of figures 2 and 3, the auxiliary modular electrical apparatus 4 comprises, without thereby introducing any limitation, four elastic conductive contact elements 35 provided for the connection of the auxiliary modular electrical apparatus 7 to the interconnection bus 30. Preferably, the auxiliary modular electrical apparatuses have a rear face 16 which comprises a recessed portion adapted to partially receive the mounting track of the mounting rail 2 and the aforesaid elastic conductive contact elements 35 project from said rear face 16 towards the interconnection bus 30 when the auxiliary modular electrical apparatuses are attached to the mounting rail 30.

The support device 40 of the interconnection bus 30 is housed in the recessed channel 22 of the mounting rail 2 and comprises a support portion 41 adapted to support the interconnection bus 30 and at least one elastically deformable coupling portion 45, for example, deformable by compression, and adapted to be fitted into the recessed channel 22 of the mounting rail 2 to engage with at least one of the side walls 21 in the recessed channel 22. Preferably, the support device 40 of the interconnection bus 30 comprises two elastically deformable coupling portions 45 placed on opposite sides to each other with respect to the support portion 41.

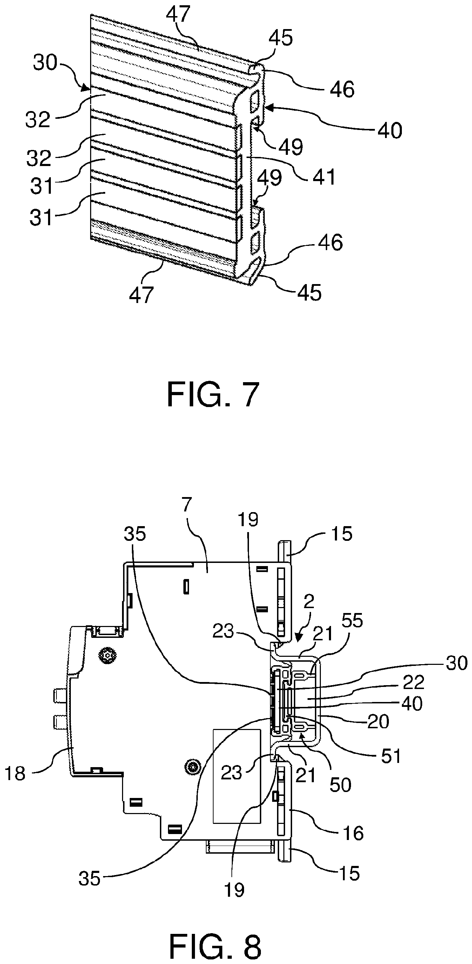

According to a first advantageous embodiment, consistent with the example represented in figures 2 and 8, the coupling portion 45 of the support device 40 is entirely housed in the recessed channel 22.

According to a second advantageous embodiment, consistent with the example represented in figures 2 and 8, the support portion 41 is entirely housed in the recessed channel 22.

According to a third advantageous embodiment, consistent with the example represented in figures 2 and 8, the interconnection bus 30 is entirely housed in the recessed channel 22.

The three embodiments just described above can also be used in combination, according to all possible combinations of two or three elements.

According to an advantageous embodiment, the coupling portion 45 is made of a relatively elastic material and the support portion 41 is made of a relatively rigid material with respect to the aforesaid relatively more elastic material. For example the aforementioned relatively elastic material is plasticised PVC and said relatively more rigid material is rigid PVC. This way, the support device 40 of the interconnection bus 30 has a certain structural rigidity making it possible to realize a stable support for the interconnection bus 30 and at the same time a certain elasticity, which allows a quick coupling of the interconnection bus 30 into the recessed channel 22 of the mounting rail 2.

According to an advantageous embodiment, the support portion 41 and the coupling portion 45 are made in one piece. Thus advantageously the number of components required is reduced. For example, the support portion 41 and the coupling portion 45 are co-moulded or co-extruded.

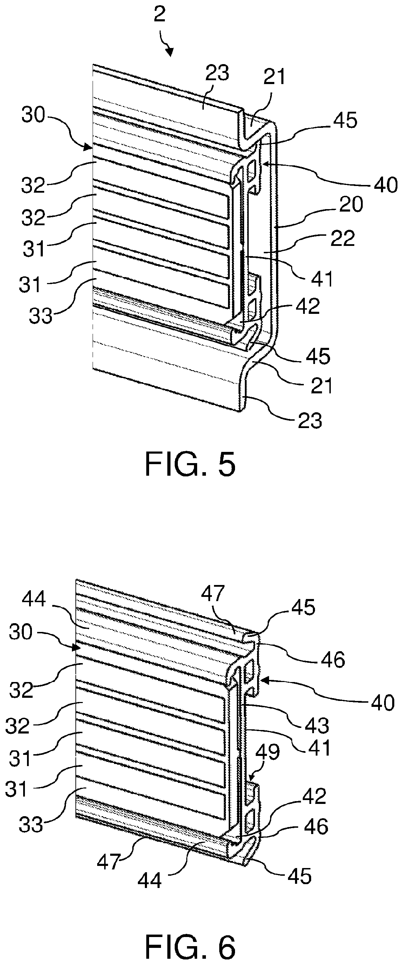

With reference to figures 6 and 7 the coupling portion 45 comprises at least one flexible wing having a first end portion 46 fixed to the support portion 41 and an opposite second free end portion 47. According to an advantageous embodiment, the aforesaid flexible wing is or comprises a wing folding with respect to a remaining portion of the support device 40 and this allows a quick coupling to the rail. In the example of figures 6 and 7, the first end portion 46 is placed closer to the bottom wall 20 of the mounting rail 2 with respect to the second end portion 47. Again in the same example, the coupling portion 45 comprises two flexible wings arranged on opposite sides with respect to the support portion 41 of the support device 40.

In the embodiment of figures 5 and 6, the support portion 41 comprises a housing channel 42 having an open side and adapted to receive and retain the interconnection bus 30. The interconnection bus 30 comprises a printed circuit board 33 having a plurality of electrically conductive lines 31,32 arranged on a face of the printed circuit board 33 so that they are exposed and accessible through said open side of the housing channel 42. Preferably, the interconnection bus 30 and the housing channel 42 are configured in such a way that the interconnection bus 30 can be slidingly inserted into the housing channel 42. For example, the support portion 41 comprises a flat wall 43 and two shaped walls 44 (for example each having an L-shaped cross section) placed on opposite sides to each other with respect to the flat wall 43 which together with the latter define the housing channel 42 and make it possible to keep the printed circuit board 33 parallel to the flat wall 43 and prevent its accidental exit from the housing channel 42.

With reference to Figure 7, in an alternative embodiment to that described in the previous paragraph, which makes it possible to further reduce the number of parts and simplifies the assembly of the system, the interconnection bus 30 comprises a plurality of electrically conductive lines 31, 32 which are integrated in the support portion 41. Preferably, the support portion 41 comprises a plurality of linear recesses each of which houses a respective electrically conductive line 31, 32. More preferably, the interconnection bus 30 and the support device 40 are made in one piece. For example, the electrically conductive lines 31, 32 are made by co-extrusion to be directly integrated into the support portion 41. It is clear that in the embodiment of figure 7, the support device 40 is made of an electrically insulating material, for example in plastic material.

According to one embodiment, the mounting rail 2 comprises a thickness adapter 50 coupling to the support device 40 of the interconnection bus 30 to be interposed between the support device 40 and the bottom wall 20 of the mounting rail 2 so that at least one support portion 55 of the thickness adapter 50 is in contact with the bottom wall 20 of the mounting rail 20. This way it is possible advantageously to stabilize the position of the support device 40 with respect to the mounting rail 2 without having to provide specific support devices 40 for mounting rails 2 having different depths of the recessed channel 22 from each other.

In order to attach the support device 40 and the thickness adapter 50 to each other, preferably, the support portion 41 comprises at least a first interlocking coupling element 49 and the thickness adapter 50 comprises at least a second interlocking coupling element 51 complementary to the first interlocking coupling element 49. The first interlocking coupling element 49 is for example a shaped channel having an open side and the second interlocking coupling element 51 is for example an appendage with a T-shaped cross-section adapted to be slidingly received in the shaped channel to couple the thickness adapter 50 to the support device.

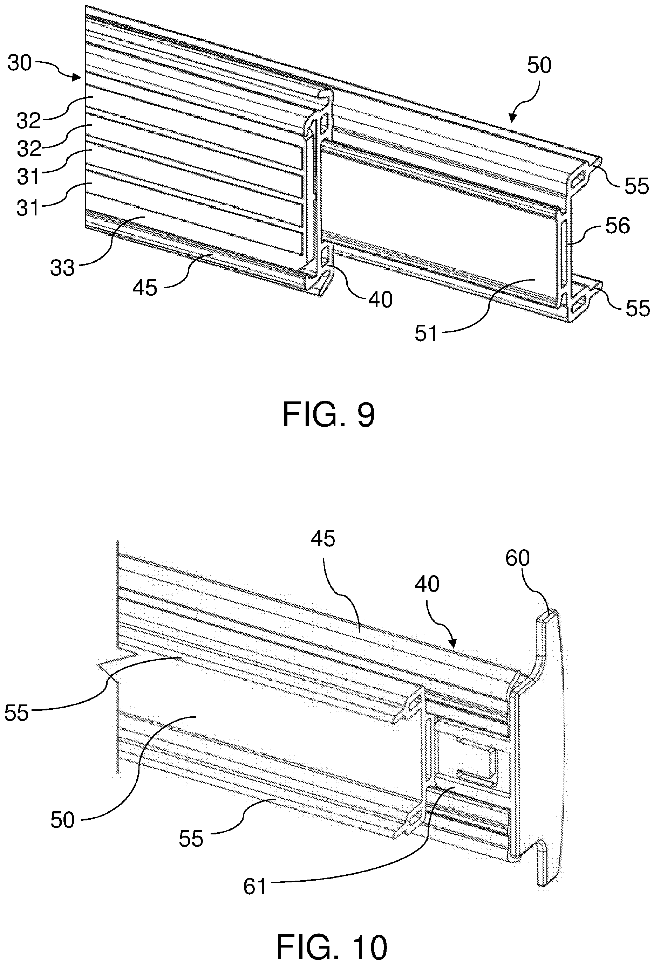

In the particular example represented in figures 8 and 9, the thickness adapter 50 comprises two support portions 55 and a central bridge portion 56 which connects the support portions 55. The interlocking coupling element 51 is an appendage with a T-shaped cross-section which projects from the central bridge portion 56.

With reference to Figure 3, according to one embodiment, the mounting rail 2 comprises two end caps 60, for example made of insulating material coupled to the longitudinally opposite end portions of the mounting rail 2. The two end caps 60 as well as having an aesthetic function and completing the assembly, increase the insulation distance between the mounting rail 2 and any metal parts of the electrical panel (e.g. uprights, guides and supports). With reference to figure 10, according to one embodiment the end cap 60 is coupled to the support device 40, for example is provided with a projecting attachment appendage 61 engaging in the interlocking coupling element 49 when this is made as a shaped channel and such as to block, preferably in a removable manner, the end cap 60 to the support device 40 of the interconnection bus 30.

From the above description it is evident that the mounting rail proposed makes it possible to fully achieve the intended purposes in terms of overcoming the drawbacks of the prior art. In fact, the support device of the interconnection bus is housed in the internal channel of the mounting rail and allows the fastening of the bus to the mounting rail, without therefore requiring external fastening devices which by engaging with the fastening bands subtract from said bands useful space for the attachment of modular electrical apparatuses to the mounting rail. Furthermore, the connection of the modular electrical apparatuses to the interconnection bus can be performed in a particularly rapid manner.

Without prejudice to the principle of the invention, the embodiments and construction details may be varied widely with respect to what has been described and illustrated purely by way of a non-limiting example, without thereby departing from the scope of the invention as defined in the appended claims.

## Claims

1. Mounting rail (2) for modular electrical apparatuses (3-9) for the control and/or distribution of electric power, comprising a profile having a bottom wall (20) and two side walls (21) connected to the bottom wall (20) and such as to delimit together with the bottom wall (20) a recessed channel (22) of the mounting rail (2), the profile comprising two fastening bands (23) each of which is joined to a respective side wall (21) and that together define a mounting track of the modular electrical apparatuses (3-9), wherein the mounting rail (2) comprises an interconnection bus (30) between the modular electrical apparatuses and a support device (40) of the interconnection bus (30) adapted to fasten the interconnection bus (30) to the mounting rail (2),
**wherein:**
- the support device (40) is housed in the recessed channel (22) of the mounting rail (2) and comprises a support portion (41) adapted to support the interconnection bus (30) and at least one coupling portion (45) elastically deformable and adapted to be inserted in the recessed channel (22) to engage at least one of the side walls (21) in the recessed channel (22);
- the coupling portion (44) comprises at least one flexible wing having a first end portion (46) fixed to the support portion (41) and an opposite second free end portion (47).

2. Mounting rail (2) for modular electrical apparatuses for the control and/or distribution of electric power according to claim 1, wherein the support device (40) of the interconnection bus (30) comprises two elastically deformable coupling portions (45) arranged on opposite sides with respect to the support portion (41).

3. Mounting rail (2) according to claim 1 or 2, wherein the support portion (41) comprises a housing channel (42) having an open side and adapted to receive and retain the interconnection bus (30) and wherein the interconnection bus (30) comprises a printed circuit board (33) having a plurality of electrically conductive lines (31, 32) arranged on a face of said board (33) facing said open side.

4. Mounting rail (2) according to claim 3, wherein the interconnection bus (30) and the housing channel (42) are configured in such a way that the interconnection bus (30) can be slidingly inserted in the housing channel (42) .

5. Mounting rail (2) according to claim 1 or 2, wherein the interconnection bus (30) comprises a plurality of electrically conductive lines (31, 32) integrated into the support portion (41).

6. Mounting rail (2) according to claim 5, wherein the support portion (41) comprises a plurality of linear recesses each adapted to accommodate a respective electrically conductive line (31, 32).

7. Mounting rail (2) according to claims 5 or 6, wherein said electrically conductive lines (31, 32) are made by co-extrusion together with said support portion (41).

8. Mounting rail (2) according to any one of the preceding claims, wherein said coupling portion (45) is made of a relatively more elastic material and said support portion (41) is made of a relatively more rigid material with respect to said relatively more elastic material.

9. Mounting rail (2) according to claim 8, wherein the support portion (41) and the coupling portion (45) are made in one piece.

10. Mounting rail (2) according to claim 9, wherein the support portion (41) and the coupling portion (45) are co-moulded or co-extruded.

11. Mounting rail (2) according to claim 1, wherein the first end portion (46) is arranged closer to said bottom wall (20) with respect to said second end portion (47).

12. Mounting rail (2) according to any one of the preceding claims, comprising a thickness adapter (50) coupling to the support device (40) to be interposed between the support device (40) and the bottom wall (20) in such a way that at least one support portion (55) of the thickness adapter (50) is in contact with the bottom wall (20).

13. Mounting rail (2) according to claim 12, wherein the support portion (41) comprises at least one first interlocking coupling element (49) and wherein said thickness adapter (50) comprises at least one second interlocking coupling element (51) complementary to the first interlocking coupling element.

14. Mounting rail (2) according to any one of the preceding claims, wherein the coupling portion (45) is entirely housed in the recessed channel (22).

15. Mounting rail (2) according to any one of the preceding claims, wherein the support portion (41) is entirely housed in the recessed channel (22).

16. Mounting rail (2) according to any one of the preceding claims, wherein the interconnection bus (30) is entirely housed in the recessed channel (22).

17. Mounting rail (2) according to claim 1 or 11, wherein said at least one flexible wing is or comprises a wing folding with respect to a remaining portion of the support device (40).

18. Electrical switchboard for the control and/or distribution of electric power, comprising at least one mounting rail (2) according to any one of the preceding claims and a plurality of modular electrical apparatuses (3-9) fixed to the mounting rail and electrically connected to the interconnection bus (30).

## Patentansprüche

1. Montageschiene (2) für modulare elektrische Vorrichtungen (3 bis 9) zur Steuerung und/oder Verteilung elektrischer Energie, mit einem Profil, das eine Bodenwand (20) und zwei mit der Bodenwand (20) verbundene Seitenwände (21) aufweist, und derart, dass gemeinsam mit der Bodenwand (20) ein vertiefter Kanal (22) der Montageschiene (2) begrenzt ist, das Profil umfassend zwei Befestigungsbänder (23), von welchen jedes mit einer jeweiligen Seitenwand (21) verbunden ist, und die gemeinsam eine Montageschiene der modularen elektrischen Vorrichtung (3 bis 9) definieren, wobei die Montageschiene (2) einen Verbindungsbus (30) zwischen den modularen elektrischen Vorrichtungen und eine Trägervorrichtung (40) des Verbindungsbusses (30) umfasst, die angepasst ist, um den Verbindungsbus (30) an der Montageschiene (2) zu befestigen,
**wobei:**
- die Trägervorrichtung (40) in dem vertieften Kanal (22) der Montageschiene (2) untergebracht ist und einen Trägerabschnitt (41) umfasst, der angepasst ist, um den Verbindungsbus (30) zu tragen, und mindestens einen elastisch verformbaren Kopplungsabschnitt (45), und der angepasst ist, um in den vertieften Kanal (22) eingesetzt zu sein, um mindestens eine der Seitenwände (21) in dem vertieften Kanal (22) in Eingriff zu nehmen;
- der Kopplungsabschnitt (44) mindestens einen flexiblen Flügel umfasst, der einen ersten Endabschnitt (46) aufweist, der an dem Trägerabschnitt (41) und einem entgegengesetzten zweiten freien Endabschnitt (47) befestigt ist.

2. Montageschiene (2) für modulare elektrische Vorrichtungen zur Steuerung und/oder Verteilung elektrischer Energie nach Anspruch 1, wobei die Trägervorrichtung (40) des Verbindungsbusses (30) zwei elastisch verformbare Kopplungsabschnitte (45) umfasst, die an entgegengesetzten Seiten in Bezug auf den Trägerabschnitt (41) eingerichtet sind.

3. Montageschiene (2) nach Anspruch 1 oder 2, wobei der Trägerabschnitt (41) einen Gehäusekanal (42) umfasst, der eine offene Seite aufweist und angepasst ist, um den Verbindungsbus (30) aufzunehmen und zu halten, und wobei der Verbindungsbus (30) eine gedruckte Leiterplatte (33) umfasst, die eine Vielzahl elektrisch leitender Leitungen (31, 32) aufweist, die auf einer der offenen Seite zugewandten Seite der Platte (33) angeordnet sind.

4. Montageschiene (2) nach Anspruch 3, wobei der Verbindungsbus (30) und der Gehäusekanal (42) derart konfiguriert sind, dass der Verbindungsbus (30) gleitend in den Gehäusekanal (42) eingesetzt werden kann.

5. Montageschiene (2) nach Anspruch 1 oder 2, wobei der Verbindungsbus (30) eine Vielzahl elektrisch leitender Leitungen (31, 32) umfasst, die in den Trägerabschnitt (41) integriert sind.

6. Montageschiene (2) nach Anspruch 5, wobei der Trägerabschnitt (41) eine Vielzahl linearer Aussparungen umfasst, von welchen jede angepasst ist, um eine jeweilige elektrisch leitende Leitung (31, 32) aufzunehmen.

7. Montageschiene (2) nach Anspruch 5 oder 6, wobei die elektrisch leitenden Leitungen (31, 32) gemeinsam mit dem Trägerabschnitt (41) durch Coextrusion hergestellt sind.

8. Montageschiene (2) nach einem der vorstehenden Ansprüche, wobei der Kopplungsabschnitt (45) aus einem relativ elastischeren Material hergestellt ist, und der Trägerabschnitt (41) aus einem relativ steiferen Material in Bezug auf das relativ elastischere Material hergestellt ist.

9. Montageschiene (2) nach Anspruch 8, wobei der Trägerabschnitt (41) und der Kopplungsabschnitt (45) einstückig hergestellt sind.

10. Montageschiene (2) nach Anspruch 9, wobei der Trägerabschnitt (41) und der Kopplungsabschnitt (45) gemeinsam geformt oder coextrudiert sind.

11. Montageschiene (2) nach Anspruch 1, wobei der erste Endabschnitt (46) näher an der genannten unteren Wand (20) bezüglich des zweiten Endabschnitts (47) eingerichtet ist.

12. Montageschiene (2) nach einem der vorstehenden Ansprüche, mit einem Dickenadapter (50), der an der Trägervorrichtung (40) koppelt, um derart zwischen der Trägervorrichtung (40) und der Bodenwand (20) eingefügt zu sein, dass mindestens ein Trägerabschnitt (55) des Dickenadapters (50) mit der Bodenwand (20) in Berührung ist.

13. Montageschiene (2) nach Anspruch 12, wobei der Trägerabschnitt (41) mindestens ein erstes verriegelndes Kopplungselement (49) umfasst, und wobei der Dickenadapter (50) mindestens ein zweites verriegelndes Kopplungselement (51) umfasst, das zu dem ersten verriegelnden Kopplungselement komplementär ist.

14. Montageschiene (2) nach einem der vorstehenden Ansprüche, wobei der Kopplungsabschnitt (45) vollständig in dem vertieften Kanal (22) untergebracht ist.

15. Montageschiene (2) nach einem der vorstehenden Ansprüche, wobei der Trägerabschnitt (41) vollständig in dem vertieften Kanal (22) untergebracht ist.

16. Montageschiene (2) nach einem der vorstehenden Ansprüche, wobei der Verbindungsbus (30) vollständig in dem vertieften Kanal (22) untergebracht ist.

17. Montageschiene (2) nach Anspruch 1 oder 11, wobei der mindestens eine flexible Flügel eine Flügelfalzung in Bezug auf einen verbleibenden Abschnitt der Trägervorrichtung (40) ist oder umfasst.

18. Elektrische Schalttafel zur Steuerung und/oder Verteilung elektrischer Energie mit mindestens einer Montageschiene (2) nach einem der vorstehenden Ansprüche und einer Vielzahl modularer elektrischer Vorrichtungen (3 bis 9), die an der Montageschiene befestigt und elektrisch mit dem Verbindungsbus (30) verbunden sind.

## Revendications

1. Rail de montage (2) pour appareils électriques modulaires (3 à 9) en vue de la régulation et/ou de la distribution d'énergie électrique, comprenant un profilé ayant une paroi de fond (20) et deux parois latérales (21) reliées à la paroi de fond (20) et destiné à délimiter, conjointement avec la paroi de fond (20), un canal en retrait (22) du rail de montage (2), le profilé comprenant deux bandes de fixation (23) dont chacune est jointe à une paroi latérale respective (21) et définissant ensemble une piste de montage des appareils électriques modulaires (3 à 9), le rail de montage (2) comprenant un bus d'interconnexion (30) entre les appareils électriques modulaires et un dispositif de soutien (40) du bus d'interconnexion (30), conçu pour fixer le bus d'interconnexion (30) au rail de montage (2),
**dans lequel :**
- le dispositif de soutien (40) tient dans le canal en retrait (22) du rail de montage (2) et comprend une partie de soutien (41), conçue pour soutenir le bus d'interconnexion (30) et au moins une partie d'accouplement (45), à déformation élastique et conçue pour être insérée dans le canal en retrait (22) pour venir en prise avec au moins une des parois latérales (21) dans le canal en retrait (22) ;
- la partie d'accouplement (44) comprend au moins une aile flexible, dont une première partie d'extrémité (46) est fixée à la partie de soutien (41), et une seconde partie d'extrémité libre opposée (47).

2. Rail de montage (2) pour appareils électriques modulaires en vue de la régulation et/ou de la distribution d'énergie électrique selon la revendication 1, dans lequel le dispositif de soutien (40) du bus d'interconnexion (30) comprend deux parties d'accouplement (45) à déformation élastique, disposées sur des côtés opposés à la partie de soutien (41).

3. Rail de montage (2) selon la revendication 1 ou 2, dans lequel la partie de soutien (41) comprend un canal de boîtier (42) à côté ouvert, conçu pour recevoir et pour retenir le bus d'interconnexion (30), le bus d'interconnexion (30) comprenant une carte de circuit imprimé (33) dont une pluralité de lignes électroconductrices (31, 32) sont agencées sur une face de ladite carte (33) tournée vers ledit côté ouvert.

4. Rail de montage (2) selon la revendication 3, dans lequel le bus d'interconnexion (30) et le canal de boîtier (42) sont configurés pour pouvoir insérer par coulissement le bus d'interconnexion (30) dans le canal de boîtier (42).

5. Rail de montage (2) selon la revendication 1 ou 2, dans lequel le bus d'interconnexion (30) comprend une pluralité de lignes électroconductrices (31, 32) intégrées à la partie de soutien (41).

6. Rail de montage (2) selon la revendication 5, dans lequel la partie de soutien (41) comprend une pluralité d'évidements linéaires, dont chacun est conçu pour loger une ligne électroconductrice respective (31, 32).

7. Rail de montage (2) selon les revendications 5 ou 6, dans lequel lesdites lignes électroconductrices (31, 32) sont réalisées par extrusion conjointe avec ladite partie de soutien (41).

8. Rail de montage (2) selon l'une quelconque des revendications précédentes, dans lequel ladite partie d'accouplement (45) est constituée d'un matériau relativement plus élastique et où ladite partie de soutien (41) est constituée d'un matériau relativement rigide par rapport audit matériau relativement élastique.

9. Rail de montage (2) selon la revendication 8, dans lequel la partie de soutien (41) et la partie d'accouplement (45) forment une seule pièce.

10. Rail de montage (2) selon la revendication 9, dans lequel la partie de soutien (41) et la partie d'accouplement (45) sont moulées ou extrudées conjointement.

11. Rail de montage (2) selon la revendication 1, dans lequel la première partie d'extrémité (46) est agencée plus près de ladite paroi inférieure (20) que ladite seconde partie d'extrémité (47).

12. Rail de montage (2) selon l'une quelconque des revendications précédentes, comprenant un adaptateur d'épaisseur (50) s'accouplant au dispositif de soutien (40) pour s'interposer entre le dispositif de soutien (40) et la paroi de fond (20), pour qu'au moins une partie de soutien (55) de l'adaptateur d'épaisseur (50) soit en contact avec la paroi de fond (20).

13. Rail de montage (2) selon la revendication 12, dans lequel la partie de soutien (41) comprend au moins un premier élément d'accouplement à emboîtement (49) et dans lequel ledit adaptateur d'épaisseur (50) comprend au moins un second élément d'accouplement à emboîtement (51), complémentaire du premier élément d'accouplement à emboîtement.

14. Rail de montage (2) selon l'une quelconque des revendications précédentes, dans lequel la partie d'accouplement (45) tient entièrement dans le canal en retrait (22).

15. Rail de montage (2) selon l'une quelconque des revendications précédentes, dans lequel la partie de soutien (41) tient entièrement dans le canal en retrait (22).

16. Rail de montage (2) selon l'une quelconque des revendications précédentes, dans lequel le bus d'interconnexion (30) tient entièrement dans le canal en retrait (22).

17. Rail de montage (2) selon la revendication 1 ou 11, dans lequel ladite au moins une aile flexible est ou comprend une aile repliable par rapport au reste du dispositif de soutien (40).

18. Tableau électrique en vue de la régulation et/ou de la distribution d'énergie électrique, comprenant au moins un rail de montage (2) selon l'une quelconque des revendications précédentes et une pluralité d'appareils électriques modulaires (3 à 9) fixés au rail de montage et connectés électriquement au bus d'interconnexion (30).
